# EUROPÄISCHE PATENTSCHRIFT

(11) **EP 3 106 915 B1**
(45) Veröffentlichungstag und Bekanntmachung des Hinweises auf die Patenterteilung: **01.08.2018**
(21) Anmeldenummer: 16170904.3
(22) Anmeldetag: 23.05.2016
(51) Int. Cl.: G02F 1/1333, G06F 1/16

(54) **RAHMEN FÜR EIN EIN- UND AUSGABEGERÄT**
FRAME FOR A DEVICE HAVING INPUT AND OUTPUT FUNCTIONS
CADRE POUR UN DISPOSITIF AYANT LES FONCTIONS D'ENTRÉE ET DE SORTIE

(30) Priorität: 15.06.2015 AT 504902015
(43) Veröffentlichungstag der Anmeldung: 21.12.2016
(73) Patentinhaber: B&R Industrial Automation GmbH, 5142 Eggelsberg (AT)
(72) Erfinder: Esterbauer, Hermann, 5121 Tarsdorf (AT); Wimmer, Johann, 5144 Handenberg (AT)
(74) Vertreter: Patentanwälte Pinter & Weiss OG

(56) Entgegenhaltungen:
- EP-A2- 2 590 489
- US-A1- 2008 151 479
- US-A1- 2015 116 629

## Beschreibung

Die gegenständliche Erfindung betrifft einen Rahmen für ein Ein- und Ausgabegerät, wobei der Rahmen aus einer Mehrzahl von einzelnen Rahmenteilen zusammengesetzt ist, wobei die Rahmenteile zur Ausbildung des Rahmens an aneinanderstoßenden Stoßflächen gefügt sind. Weiters betrifft die Erfindung ein Ein- und Ausgabegerät mit einem solchen Rahmen und ein Herstellungsverfahren für den Rahmen und das Ein- und Ausgabegerät.

Ein Großteil der modernen Ein- und Ausgabegeräte als Mensch-Maschine-Schnittstelle basiert auf Display- oder auch Touchscreen-Technologie als Ein- und Ausgabeeinheiten. Auch Tasten, Knöpfe, Schalter, etc. sind als Ein- und Ausgabeeinheiten weit verbreitet. Das gilt insbesondere und immer verstärkter auch für industrielle Anwendungen, wie z.B. die Steuerung von Maschinen und Anlagen. Aufgrund der steigenden Automatisierung sind entsprechende bildwiedergebende Ein- und Ausgabegeräte, wie z.B. Displays, Touchscreens, etc., an Werkzeug-, Bearbeitungs- und Verarbeitungsmaschinen, Schaltschränken, Überwachungs- und Steuerungseinheiten für Prozess- und Ablaufsteuerung und dergleichen weit verbreitet.

Gerade durch die Verwendung von Ein- und Ausgabegeräten im Zusammenhang mit der industriellen Nutzung sind die Ansprüche an derartige Geräte im industriellen Umfeld in Bezug auf mechanische Robustheit und Widerstandsfähigkeit gegenüber den äußeren Einflüssen und Gegebenheiten entsprechend gestiegen. Diese Anforderungen können in keiner Weise mit den Anforderungen an herkömmliche Ein- und Ausgabegeräten, insbesondere Displays wie sie z.B. im privaten Umfeld bei Monitoren und Fernsehgeräten vorkommen, verglichen werden.

Üblicherweise werden Ein- und Ausgabegeräte für den industriellen Einsatz ausgeführt, dass entsprechend stabile und widerstandsfähige Gehäuse bzw. Rahmen für diese Ein- und Ausgabegeräte vorgesehen werden. Aus diesem Grund werden Geräterahmen für industriell genutzte Ein- und Ausgabegeräte aus Metall, typischerweise aus Aluminium, gefertigt.

Daneben kann es noch Anforderungen an die Dichtheit der Ein- und Ausgabegeräte geben, da es im industriellen Umfeld oftmals Spritzwasser geben kann, gegen das das Display abgedichtet sein muss. Auch während der Reinigung einer Maschine oder Anlage, kann es zu einer Spritzwasserbelastung kommen, gegen die das Display zu schützen ist.

Gleichfalls werden oftmals auch Anforderungen hygienischer Natur gestellt. Hier geht es insbesondere darum, Möglichkeiten für eine Schmutzablagerung am Display weitestgehend zu unterbinden. Dabei sollen vor allem Rillen, Spalten und Vertiefungen am Display bzw. am Displayrahmen vermieden werden.

Um all diese Anforderungen erfüllen zu können, werden nach derzeitigem Stand der Technik Displays für industrielle Anwendungen mit einteiligen, das Display aufnehmenden Rahmen gefertigt.

Aufgrund der geringen Stückzahlen solcher Displays für den industriellen Einsatz, werden diese Rahmen nach heutigem Stand der Technik durch spanende Bearbeitung aus dem Vollen, beispielsweise durch Fräsen, gefertigt. Hierbei kommt es naturgemäß zu sehr hohen Materialverlusten, was die Kosten für solche Displayrahmen erhöht und auch die Fertigung aufwendig und ineffizient macht.

Grundsätzlich könnten solche einteiligen Displayrahmen auch im Druck- oder Spritzgussverfahren gefertigt werden, was sich aufgrund der Kleinstserien durch die hohen Werkzeugkosten (z.B. für Druckgussformen) aber kaum rechnet.

Aus der CN 2844970 Y ist ein Rahmen für ein LCD-Display bekannt, der aus einzelnen Rahmenteilen zusammengesetzt wird. Die Rahmenteile werden dabei aus einer Platte des Displaymaterials herausgeschnitten, zu einem Rahmen zusammengelegt und die flachen Rahmenteile werden an den Stoßstellen gefügt (Z.B. durch Löten, Schweißen oder Nieten). Danach werden die Ecken des flachen Rahmens ausgestanzt und die Seiten umgebogen, um einen Rahmen mit einem L-förmigen Querschnitt zu formen. Es ist offensichtlich, dass ein solcher Rahmen an den Ecken, an denen die umgebogenen Seiten aneinander liegen, nicht dicht sein kann. Ein solcher Rahmen ist daher für eine industrielle Anwendung ungeeignet.

Auch aus der KR 10 2005 0027375 A ist ein Rahmen für ein Flachdisplay bekannt, der aus einzelnen Rahmenteilen zusammengesetzt ist. Hier sind die Rahmenteile Plastikteile in Form von Pressteilen, die an den Stoßstellen verschweißt werden. Der Rahmen weist an den Ecken eine Ausnehmung aus, womit der Rahmen nicht dicht ausgeführt ist und daher nicht für den industriellen Einsatz geeignet ist.

Die US/2008/151479 A1 offenbart einen Rahmen für eine Flüssigkristallanzeige, der aus einer Mehrzahl von Rahmenteilen zusammengesetzt ist. Die Rahmenteile werden entweder zusammengeschweißt oder zusammengeklebt. Als Option werden auch Steckverbindungen vorgeschlagen. Auch die US 2015/116629 A1 offenbart eine Flüssigkristallanzeige, deren vorderer Rahmen aus Rahmenteilen besteht, welche zusammengeschweißt wird.

Ein Rahmen für ein Ein- und Ausgabegerät für den industriellen Einsatz weist in der Regel auch eine komplexe Querschnittsform auf, die sich im Wesentlichen daraus ergibt, dass Nuten für die Aufnahme von Dichtungen, für die Befestigung an anderen Bauteilen oder für andere Bauteile, aber auch Nuten und Ausnehmungen für die Aufnahme des Ein- und Ausgabegerät selbst notwendig sind. Die Rahmen sind dabei in den Abmessungen auch so klein wie möglich auszuführen. Das führt dazu, dass ein vollständiges Verschweißen oder Verlöten an den Stoßstellen aus fertigungstechnischen Gründen kaum möglich ist, oder ein aufwendiges Nachbearbeiten notwendig macht.

Die Aufgabe der gegenständlichen Erfindung besteht daher darin, einen Rahmen für ein Ein- und Ausgabegerät und ein Ein- und Ausgabegerät für den industriellen Einsatz möglichst kostengünstig herzustellen, welches darüber hinaus den oben genannten Anforderungen im industriellen Umfeld, insbesondere den Dichtheitsanforderungen, gerecht wird.

Diese Aufgabe wird erfindungsgemäß dadurch gelöst, dass im Bereich einer Stoßfläche eine Durchgangsausnehmung angeordnet ist, die mit der Stoßfläche verbunden ist und die eine Stirnseite des Rahmens mit einer gegenüberliegenden Stirnseite des Rahmens verbindet, wobei die Durchgangsausnehmung mit einer Dichtmasse ausgefüllt ist. Durch von der Stoßfläche geteilte Durchgangsausnehmung wird der Spalt zwischen den aneinander liegenden Rahmenteilen durch die Dichtmasse in der Durchgangsausnehmung geschlossen. Damit kann kein Medium von außen durch diesen Spalt in den Rahmen eindringen und der Rahmen ist entlang der äußeren Umfangsfläche vollständig geschlossen.

Mit einem solchen Rahmen kann auf einfache Weise ein Ein- und Ausgabegerät für den industriellen Einsatz ausgebildet werden, indem in eine zentrale Ausnehmung des Rahmens eine Ein- und Ausgabeeinheit eingesetzt wird. Aufgrund des dichten Rahmens erfüllt das Ein- und Ausgabegerät die hohen Anforderungen an die Dichtheit.

Die Stirnseiten, die durch die Durchgangsausnehmung verbunden werden, werden bevorzugt vom Grund einer Umfangnut in der äußeren Stirnseite des Rahmens und vom Grund einer gegenüberliegenden Dichtungsausnehmung ausgebildet. Dabei ist es auch vorteilhaft, wenn am Rahmen ein über den Umfang geschlossener Umfangskragen vorgesehen ist, der die innere Stirnseite ausbildet.

Um das Ein- und Ausgabegerät stirnseitig abzudichten, ist es vorteilhaft, wenn zwischen Rahmen und Ein- und Ausgabeeinheit ein Dichtelement angeordnet ist oder eine Abdeckfolie vorgesehen ist, die zumindest einen Spalt zwischen Rahmen und Ein- und Ausgabeeinheit abdeckt.

Das erfindungsgemäße Verfahren zeichnet sich dadurch aus, dass Rahmenteile von einem Profil unter Ausbildung der Stoßflächen abgelängt werden, die Rahmenteile an den Stoßflächen zur Ausbildung des Rahmens aneinandergelegt und gefügt werden, im Bereich aneinanderstoßender Stoßflächen eine Durchgangsausnehmung, die von den Stoßflächen geteilt wird, ausgebildet wird, womit eine erste Stirnseite des Rahmens mit einer gegenüberliegenden zweiten Stirnseite des Rahmens durch die Durchgangsausnehmung verbunden ist, und die Durchgangsausnehmung mit einer Dichtmasse gefüllt wird. Dieses Verfahren kann auf verfügbare, günstige Halbzeuge in Form von fertigen Profilen zugreifen, die nur auf die richtige Länge abgelängt werden müssen. Das ermöglicht es auch, auf einfache Weise Rahmen beliebiger Dimension zu fertigen. Zum Abdichten des Rahmens muss nur mehr eine Durchgangsausnehmung mit einer Dichtmasse ausgefüllt werden, was ebenfalls ein einfacher und automatisierbarer Arbeitsschritt ist. Damit kann der Rahmen auf einfache Weise in wenigen Arbeitsschritten und auch vollautomatisiert hergestellt werden. Eine Nachbearbeitung des derart hergestellten Rahmens ist nicht mehr erforderlich, was die Herstellung auch besonders wirtschaftlich macht.

Aus hygienischen Gründen kann es vorteilhaft sein, den Rahmen außen zumindest teilweise zu lackieren, eloxieren oder mit einer Folie zu überkleben, da damit allfällig verbleibende Spalte, in denen sich Schmutz oder Bakterien ansammeln können, geschlossen werden können.

Die gegenständliche Erfindung wird nachfolgend unter Bezugnahme auf die Figuren 1 bis 5 näher erläutert, die beispielhaft, schematisch und nicht einschränkend vorteilhafte Ausgestaltungen der Erfindung zeigen. Dabei zeigt
Fig.1 ein erfindungsgemäßes Ein- und Ausgabegerät,
Fig.2 die Befestigung des erfindungsgemäßen Ein- und Ausgabegeräts an einer Trägerplatte,
Fig.3 eine bevorzugte Ausgestaltung des erfindungsgemäßen Rahmens,
Fig.4 eine Detailansicht einer Ecke des erfindungsgemäßen Rahmens und
Fig.5 eine Detailansicht einer Stoßfläche eines Rahmenteils des erfindungsgemäßen Rahmens.

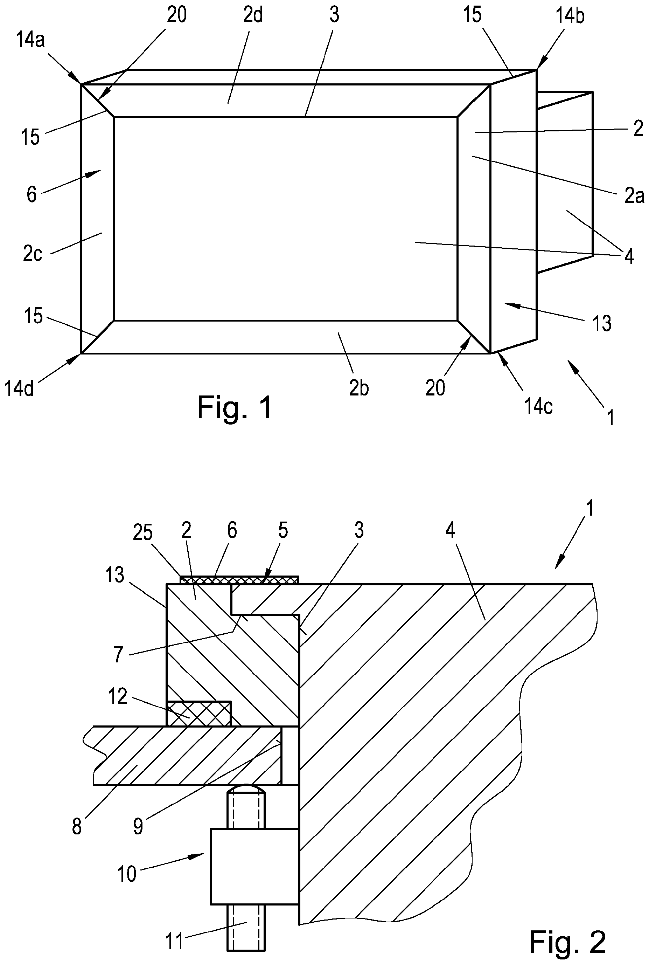

Fig.1 zeigt ein erfindungsgemäßes Ein- und Ausgabegerät 1 für ein industrielles Umfeld mit einem Rahmen 2 mit einer zentralen, axial durch den Rahmen 2 durchgehenden Ausnehmung 3, in die eine Ein- und Ausgabeeinheit 4, z.B. ein Display, ein Touchscreen, eine Einheit mit Tasten, Knöpfen oder Schaltern oder auch eine Kombination solcher Elemente, eingesetzt ist. Die Ein- und Ausgabeeinheit 4 kann auf verschiedenste Weise in das Ein- und Ausgabegerät 1 eingesetzt sein. Das Ein- und Ausgabegerät 1 bzw. der Rahmen 2 weist eine äußere Umfangsfläche 13 und eine äußere Stirnfläche 6 auf, die im bestimmungsgemäßen Einsatz des Ein- und Ausgabegerätes 1 sichtbar sind.

Im Ausführungsbeispiel nach Fig.2 weist die Ein- und Ausgabeeinheit 4 einen äußeren um den Umfang umlaufenden Umfangssteg 5 auf. Der Rahmen 2 hat an seiner äußeren Stirnseite 6, also die Stirnseite, die im betriebsgemäßen Einsatz des Ein- und Ausgabegerätes 1 sichtbar ist, eine zum Umfangssteg 5 komplementäre Umfangsnut 7, in der der Umfangssteg 5 zu liegen kommt. Vorzugsweise werden Umfangssteg 5 und Umfangsnut 7 dimensioniert, um eine bündig durchgehende äußere Stirnfläche des Ein- und Ausgabegeräts 1 zu erhalten, wie in Fig.2 angedeutet. Die Ein- und Ausgabeeinheit 4 kann aber auch direkt auf der Stirnseite 6 anliegen, wofür keine Umfangsnut 7 erforderlich wäre. Die Ein- und Ausgabeeinheit 4 kann mit dem Rahmen 2, vorzugsweise zwischen Umfangssteg 5 und Umfangsnut 7, verklebt sein, um diese am Rahmen 2 zu fixieren. Das Verkleben erfolgt z.B. mittels eines dispensierten Klebers, der gleichzeitig auch als Dichtelement 21 fungiert und für die Dichtheit an der Klebestellte sorgen kann. Dazu ist es vorteilhaft, wenn der Kleber über den Umfang geschlossen zwischen Umfangssteg 5 und Umfangsnut 7 appliziert wird. Es ist aber auch denkbar, die Ein- und Ausgabeeinheit 4 auf andere oder zusätzliche Weise am Rahmen 2 zu fixieren, z.B. durch Schraub-, Klemm-, Schnappverbindungen oder ähnliches. Zwischen Umfangsnut 7 und Umfangssteg 5 können daher auch andere, oder zusätzliche, geeignete Dichtelemente 21, wie z.B. O-Ringe, angeordnet sein.

Das Ein- und Ausgabegerät 1 wird in der Regel in eine Montageausnehmung 9 einer Trägerplatte 8, z.B. an einem Schaltschrank oder einem Bedienteil einer Maschine, eingesetzt, wobei der Rahmen 2 an der Trägerplatte 8 anliegt und über den Rahmen 2 mit der Trägerplatte 8 verbunden wird, wie in Fig.2 gezeigt. Vorgesehen sein kann z.B. eine Befestigungsvorrichtung 10 an der Ein- und Ausgabeeinheit 4, beispielsweise in Form einer Schraube 11, mit der das Ein- und Ausgabegerät 1 an der Montageplatte 8 befestigt werden kann. Mittels der Schraube 11 kann der Rahmen 2 mit der Trägerplatte 8 verklemmt werden und damit das Ein- und Ausgabegerät 1 fixiert werden. Ebenso kann zwischen Rahmen 2 und Trägerplatte 8 eine Dichtung 12 angeordnet sein, wie z.B. in der EP 2 590 489 A2 beschrieben. Die Dichtung 12 kann aber auch als dispensierter Kleber realisiert sein, wobei der Kleber bei der Montage des Ein- und Ausgabegeräts 1 an der Trägerplatte 8 aufgebracht wird. Für eine rundum dichte Abdichtung ist der Kleber über den Umfang geschlossen aufzubringen.

Der Rahmen 2 wird erfindungsgemäß aus einer Mehrzahl von einzelnen Rahmenteilen 2a, 2b, 2c, 2d, im Beispiel nach Fig.1 vier Rahmenteile, zusammengesetzt. Die Rahmenteile 2a, 2b, 2c, 2d sind bevorzugt aus auf die benötigte Länge abgelängten Profilen, z.B. aus Metall oder Kunststoff, gebildet. Die Profile können Voll- oder Hohlprofile mit im Wesentlichen beliebigem Querschnitt sein. Vorteilhaft ist vorgesehen, dass die Metall- oder Kunststoffprofile, welche die Rahmenteile 2a, 2b, 2c, 2d bilden, Strangpressprofile und/oder Strangziehprofile sind. Strangpressen stellt eine besonders kostengünstige und effiziente Herstellungstechnik für entsprechende Profile dar und ist aus diesem Grund weitläufig verbreitet. Solche Profile sind verhältnismäßig kostengünstig, schnell und in ausreichenden Mengen verfügbar.

Die Rahmenteile 2a, 2b, 2c, 2d sind an den Ecken 14a, 14b, 14c, 14d des Rahmens 2 miteinander verbunden. Hierzu können die Rahmenteile 2a, 2b, 2c, 2d, wie in Fig.1 gezeigt, an den Ecken14a, 14b, 14c, 14d des Rahmens 2 auf Gehrung geschnitten sein. Anstelle einer Gehrung können die Rahmenteile 2a, 2b, 2c, 2d, vor allem bei Vollprofilen, an den Ecken14a, 14b, 14c, 14d auch einfach auf Stoß aneinander gefügt sein. Ebenso ist es denkbar, dass die Rahmenteile 2a, 2b, 2c, 2d an den Ecken14a, 14b, 14c, 14d verzinkt sind. Grundsätzlich ist es auch denkbar, dass die Stoßstellen nicht an den Ecken ausgebildet sind, sondern irgendwo entlang der Seiten des Rahmens 2. Dabei würden zwei U-förmige Rahmenteile oder U-förmige und gerade Rahmenteile gefügt. Die zu fügenden U-förmigen Rahmenteile könnten in einem Zwischenschritt aus abgelängten Profilen hergestellt werden.

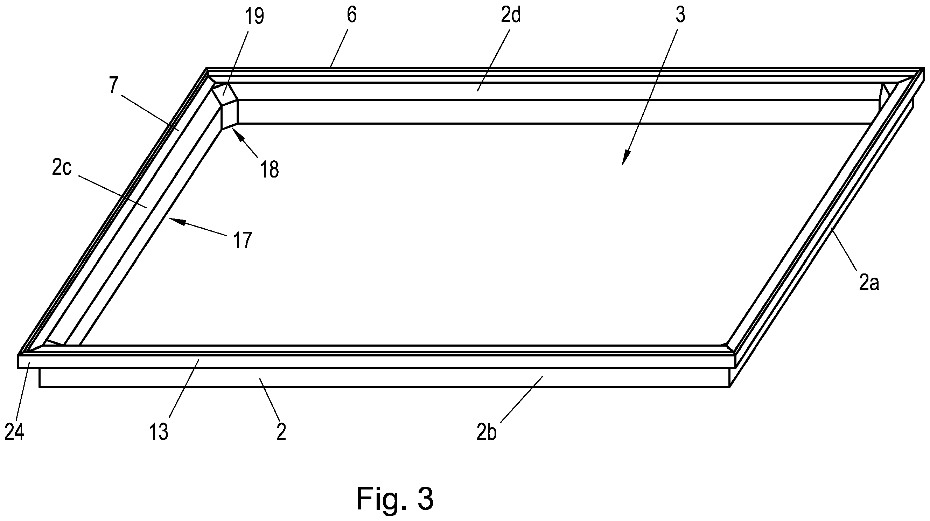

Jeweils zwei aneinander stoßende Rahmenteile 2a, 2b, 2c, 2d sind an deren einander zugewandten Stoßflächen 15, z.B. Gehrungsflächen, Stoßstellen oder Verzinkungsflächen, durch ein Fügeverfahren miteinander verbunden, wie nachfolgend anhand der Figuren 3 bis 5 näher beschrieben wird.

Aufgrund der komplexen Querschnittsform des Rahmes 2, beispielsweise mit der Umfangsnut 7 und der Dichtungsausnehmung 23 für die Dichtung 12, und der geringen Abmessungen ist der Fügeprozess fertigungstechnisch aufwendig, wenn die angestrebte Dichtheit und saubere Oberfläche erzielt werden soll. Das fertige Ein- und Ausgabegerät 1 muss für den industriellen Einsatz an der äußeren Stirnseite 6 und an der äußeren Umfangsfläche 13 des Rahmens 2 vollständig geschlossen sein. Vollständig geschlossen bedeutet dabei, dass kein Medium, wie z.B. Spritzwasser oder Reinigungsmittel, von außen in das Innere des Ein- und Ausgabegeräts 1 eindringen kann. Dazu muss auch der Rahmen 2 von außen nach innen vollständig abdichten, was durch den folgend beschriebenen erfindungsgemäßen Rahmen 2 und den erfindungsgemäßen Herstellungsprozess sichergestellt wird.

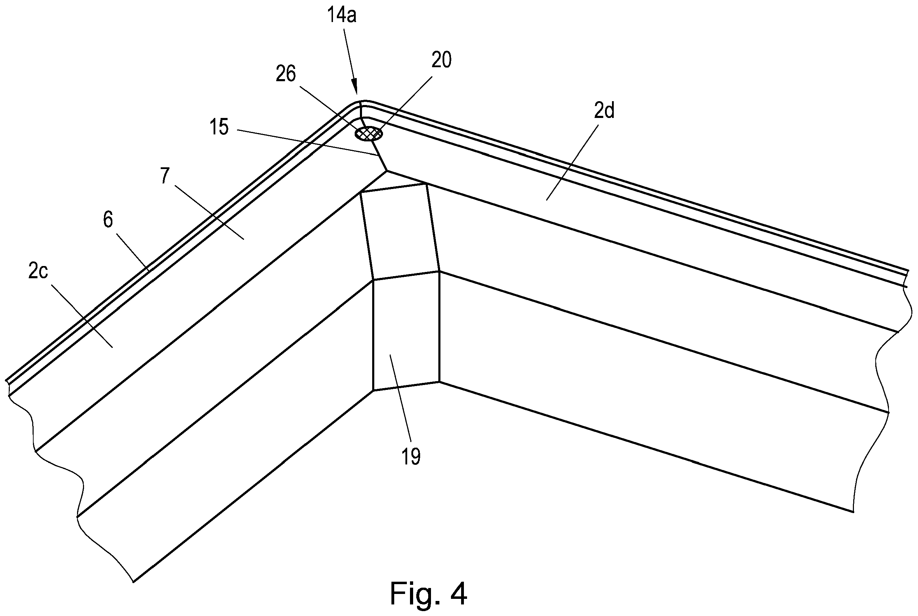

Der erfindungsgemäße Rahmen 2 in Fig.3 besteht wieder aus vier Rahmenteilen 2a, 2b, 2c, 2d, die an den Ecken auf Gehrung geschnitten sind und zur Ausbildung des Rahmens 2 an den die Stoßflächen 15 ausbildenden Gehrungsflächen aneinander liegend angeordnet sind. Die Rahmenteile 2a, 2b, 2c, 2d sind an der Innenseite 17 des Rahmens 2 in den entstehenden Innenecken 18 mit einer Schweißnaht 19 verschweißt. Bevorzugt, aber nicht zwingend, erstreckt sich die Schweißnaht 19 über die Höhe der Innenseite 17 des Rahmens 2, wie auch im Detail in der Fig.4 dargestellt ist.

Anstelle einer Schweißung könnte auch ein anderes geeignetes Fügeverfahren, insbesondere ein stoffschlüssiges Fügeverfahren, verwendet werden. Beispielsweise könnten aneinanderstoßende Rahmenteile 2a, 2b, 2c, 2d an den Stoßflächen 15 punktuell gelötet oder stellenweise verklebt werden.

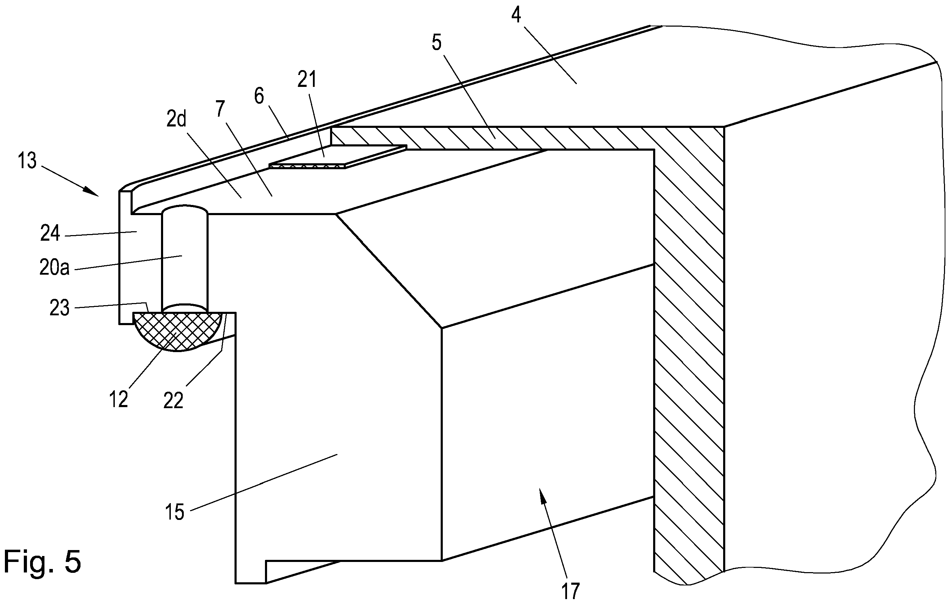

Stirnseitig wird der Rahmen 2 durch die Ein- und Ausgabeeinheit 4 und das Dichtelement 21 zwischen der Ein- und Ausgabeeinheit 4, vorzugsweise dem Umfangssteg 5, und dem Rahmen 2, vorzugsweise der Umfangsnut 7, wie oben beschrieben abgedichtet, wie in Fig.5 angedeutet. Das Dichtelement 21 umgibt dabei die zentrale Ausnehmung 3 zur Aufnahme der Ein- und Ausgabeeinheit 4 und ist über den Umfang geschlossen. Wenn kein Dichtelement 21 angeordnet wird, kann der Rahmen 2 stirnseitig auch durch eine Abdeckfolie 25 abgedichtet werden, die nach dem Einsetzen der Ein- und Ausgabeeinheit 4 stirnseitig über die Ein- und Ausgabeeinheit 4 und die anschließende äußere Stirnfläche 6 des Rahmens 2 geklebt wird (wie in Fig. 2 angedeutet). Mit der Abdeckfolie 25 könnte die Ein- und Ausgabeeinheit 4 gleichzeitig auch im Rahmen 2 fixiert werden. Die Abdeckfolie 25 muss dabei zumindest den Spalt zwischen Rahmen 2 und Ein- und Ausgabeeinheit 4 abdecken. Damit ist der Rahmen 2 stirnseitig von außen nach innen abgedichtet, d.h., dass über die äußere Stirnseite des Ein- und Ausgabegeräts 1 kein Medium eindringen kann.

Um auch die äußere Umfangsfläche 13 des Rahmens 2 nach innen abzudichten, ist im Bereich der Stoßfläche 15 eine Durchgangsausnehmung 20, beispielsweise eine Bohrung, vorgesehen, die am Rahmen 2 mit der Stoßfläche 15 verbunden ist. Die Durchgangsausnehmung 20 wird entweder nach dem Fügen der aneinanderstoßenden Rahmenteile 2a, 2b, 2c, 2d eingebracht, indem der Rahmen 2 durchbohrt wird. Ebenso ist es möglich an den Rahmenteilen 2a, 2b, 2c, 2d in die Stoßflächen 15 Ausnehmungen 20a einzuarbeiten, die nach dem Zusammenfügen der Rahmenteile 2a, 2b, 2c, 2d die Durchgangsausnehmung 20 ausbilden. In diesem Fall wird die Durchgangsausnehmung 20 von den Stoßflächen 15 geteilt. Es ist aber grundsätzlich ausreichend, wenn nur einer von zwei aneinanderstoßenden Rahmenteilen 2a, 2b, 2c, 2d eine solche Ausnehmung 20a aufweist, solange die Ausnehmung 20 mit der Stoßfläche 15 verbunden ist. Diese Durchgangsausnehmung 20 wird nach dem Fügen der Rahmenteile 2a, 2b, 2c, 2d vollständig mit einer Dichtmasse ausgefüllt, z.B. ausgegossen oder ausgespritzt. Die Durchgangsausnehmung 20 muss sich zwischen einer äußeren ersten und einer inneren zweiten Stirnseite des Rahmens 2 erstrecken, z.B. zwischen dem Grund der Umfangsnut 7 oder der Stirnseite 6 und der gegenüberliegenden Stirnseite 22. Bevorzugt erstreckt sich die Durchgangsausnehmung 20 zwischen dem Grund der Umfangsnut 7 und dem Grund einer Dichtungsausnehmung 23, die an der gegenüberliegenden Stirnseite 22 eingebracht ist und in der die Dichtung 12 zur Montageplatte 8 angeordnet wird.

Vorteilhaft ist am Rahmen 2 ein über den Umfang umlaufender, vorstehender Umfangskragen 24 vorgesehen, der die der äußeren Stirnseite 6 gegenüberliegende innere Stirnseite 22 ausbildet. Der Umfangskragen 24 kann dann an der Montageplatte 8 anliegen und der Rahmen 2 kann in die Montageausnehmung 9 eingesetzt werden. Das ermöglicht es auch, die Befestigungsvorrichtung 10 am Rahmen 2 zu befestigen und nicht an der Ein- und Ausgabeeinheit 4.

Die mit Dichtmasse 26 ausgefüllte Durchgangsausnehmung 20 dichtet den Rahmen 2 gegen Eindringen von Medium über die äußere Umfangsfläche 13 und entlang der aneinanderstoßenden Stoßflächen 15 ab.

Dabei ist es selbstverständlich, dass die Position der Dichtung 12, und gegebenenfalls des Dichtelements 21, und der Durchgangsausnehmung 20 zur Erfüllung der Dichtfunktion aneinander anzupassen sind. Die Durchgangsausnehmung 20 darf nicht weiter von der äußeren Umfangsfläche 13 entfernt angeordnet sein, als die Dichtung 12, da ansonsten Medium zwischen der Dichtung 12 und der Durchgangsausnehmung 20 durchdringen kann. Vorzugsweise überdecken sich die Durchgangsausnehmung 20 und die Dichtung 12 zumindest teilweise (wie in Fig.5 angedeutet). Dazu mündet die Durchgangsausnehmung 20 bevorzugt zumindest teilweise in die Dichtungsausnehmung 23. Gleichfalls darf die Durchgangsausnehmung 20 nicht näher an der äußeren Umfangsfläche 13 angeordnet sein, als ein Dichtelement 21, da ansonsten Medium zwischen dem Dichtelement 21 und der Durchgangsausnehmung 20 durchdringen kann. Vorzugsweise überdecken sich die Durchgangsausnehmung 20 und das Dichtelement 21 zumindest teilweise (wie in Fig.5 angedeutet). Wird zur Abdichtung eine Abdeckfolie 25 verwendet, ist die Position der Durchgangsausnehmung 20 am Grund der Umfangsnut 7 unerheblich.

Grundsätzlich ist es vorteilhaft, die Durchgangsausnehmung 20 so nahe wie möglich an der äußeren Umfangsfläche 13 anzuordnen. Dadurch kann auch der restliche Spalt zwischen den zugewandten Stoßflächen 15 reduziert werden, was aus hygienischen Gründen vorteilhaft ist.

Aus hygienischen Gründen kann es erwünscht sein, den verbleibenden Spalt zwischen Durchgangsausnehmung 20 und der äußeren Umfangsfläche 13 zu schließen. Das kann durch eine äußere Lackierung, Eloxierung oder Beschichtung des Rahmens 2 oder durch eine Überklebung des Rahmens 2 mit einer Folie erfolgen. Gleichfalls könnte der verbliebene Spalt auch bei Ausfüllen der Durchgangsausnehmung 20 mit Dichtmasse ausgefüllt werden.

Ein Herstellungsverfahren für einen erfindungsgemäßen Rahmen 2 könnte wie folgt ablaufen:
- Ablängen der Rahmenteile 2a, 2b, 2c, 2d von Profilen und gleichzeitige Ausbildung der Stoßflächen 15, beispielsweise durch Gehrungsschnitte;
- Aneinanderlegen und gegebenenfalls Fixieren der Rahmenteile 2a, 2b, 2c, 2d zu einem Rahmen 2;
- Fügen der Rahmenteile 2a, 2b, 2c, 2d, vorzugsweise durch Verschweißen der Rahmenteile 2a, 2b, 2c, 2d an den Innenecken;
- Einbringen der Durchgangsausnehmungen 20 im Bereich der Stoßflächen 15 oder Ausbilden der Durchgangsausnehmung 20 im Bereich der Stoßflächen 15 durch das Fügen der Rahmenteile 2a, 2b, 2c, 2d;
- Ausfüllen der Durchgangsausnehmung 20 mit einer Dichtmasse 26.

Danach könnte der Rahmen 2 außen noch lackiert, eloxiert, beschichtet oder mit einer Folie beklebt werden.

Dieses Herstellungsverfahren erlaubt es, einen Rahmen zu fertigen, der die hohen Anforderungen an die Dichtheit, und gegebenenfalls auch an die Hygiene, erfüllt, und der keinerlei Nachbearbeiten erfordert. Insbesondere ist es nicht notwendig, aufwendig eine Schweißstelle nachzubearbeiten oder ausgetretenen Kleber oder Schmelzlot zu entfernen. Ebenso kann die Herstellung vollautomatisiert erfolgen. Beides macht das Herstellungsverfahren besonders wirtschaftlich.

Zur Fertigung des Ein- und Ausgabegeräts 1 muss nur mehr die Ein- und Ausgabeeinheit 4 in den Rahmen 2 eingesetzt werden, wobei vorzugsweise ein Dichtelement 21 zwischen Rahmen 2 und der Ein- und Ausgabeeinheit 4 anzuordnen ist. In einer bevorzugten Ausgestaltung wird am fertigen Rahmen 2, oder an der Ein- und Ausgabeeinheit 4 an der dafür vorgesehenen Stelle ein geeigneter Kleber über den Umfang geschlossen dispensiert und danach die Ein- und Ausgabeeinheit 4 an den Rahmen 2 gepresst, bis der Kleber ausgehärtet ist.

## Patentansprüche

1. Rahmen für ein Ein- und Ausgabegerät, wobei der Rahmen (2) aus einer Mehrzahl von einzelnen Rahmenteilen (2a, 2b, 2c, 2d) zusammengesetzt ist, wobei die Rahmenteile (2a, 2b, 2c, 2d) zur Ausbildung des Rahmens (2) an aneinanderstoßenden Stoßflächen (15) der Rahmenteile (2a, 2b, 2c, 2d) gefügt sind, **dadurch gekennzeichnet, dass** im Bereich einer Stoßfläche (15) eine Durchgangsausnehmung (20) angeordnet ist, die mit der Stoßfläche (15) verbunden ist und die eine erste Stirnseite des Rahmens (2) mit einer gegenüberliegenden zweiten Stirnseite des Rahmens (2) verbindet, wobei die Durchgangsausnehmung (20) mit einer Dichtmasse (26) ausgefüllt ist.

2. Rahmen nach Anspruch 1, **dadurch gekennzeichnet, dass** an der ersten Stirnseite (6) des Rahmens eine Umfangsnut (7) vorgesehen ist und die Durchgangsausnehmung (20) den Grund der Umfangnut (7) mit der gegenüberliegenden zweiten Stirnseite verbindet.

3. Rahmen nach Anspruch 1 oder 2, **dadurch gekennzeichnet, dass** an der zweiten Stirnseite (22) des Rahmens (2) eine Dichtungsausnehmung (23) vorgesehen ist und die Durchgangsausnehmung (20) den Grund der Dichtungsausnehmung (23) mit der gegenüberliegenden ersten Stirnseite verbindet.

4. Rahmen nach Anspruch 3, **dadurch gekennzeichnet, dass** am Rahmen (2) ein über den Umfang geschlossener Umfangskragen (24) vorgesehen ist, der die zweite Stirnseite (22) ausbildet.

5. Ein- und Ausgabegerät für den industriellen Einsatz mit einem Rahmen (2) nach einem der Ansprüche 1 bis 4, wobei in eine zentral durchgehende Ausnehmung (3) des Rahmens, eine Ein-Ausgabeeinheit (4) eingesetzt ist.

6. Ein- und Ausgabegerät nach Anspruch 5, **dadurch gekennzeichnet, dass** zwischen Rahmen (2) und Ein- und Ausgabeeinheit (4) ein Dichtelement (21) angeordnet ist.

7. Ein- und Ausgabegerät nach Anspruch 5, **dadurch gekennzeichnet, dass** eine Abdeckfolie (25) vorgesehen ist, die zumindest einen Spalt zwischen Rahmen (2) und Ein- und Ausgabeeinheit (4) abdeckt.

8. Verfahren zur Herstellung eines Rahmens (2) für ein Ein- und Ausgabegerät (1), wobei Rahmenteile (2a, 2b, 2c, 2d) von einem Profil unter Ausbildung von Stoßflächen (15) abgelängt werden, die Rahmenteile (2a, 2b, 2c, 2d) an den Stoßflächen (15) zur Ausbildung des Rahmens (2) aneinandergelegt und gefügt werden, im Bereich aneinanderstoßender Stoßflächen (15) eine Durchgangsausnehmung (20), die mit den Stoßflächen (15) verbunden ist, ausgebildet wird, womit eine erste Stirnseite (6) des Rahmens mit einer gegenüberliegenden zweiten Stirnseite des Rahmens (2) durch die Durchgangsausnehmung (20) verbunden ist, und die Durchgangsausnehmung (20) mit einer Dichtmasse (26) gefüllt wird.

9. Verfahren nach Anspruch 8, **dadurch gekennzeichnet, dass** der Rahmen (2) außen zumindest teilweise lackiert, eloxiert, beschichtet oder mit einer Folie überklebt wird.

10. Verfahren zur Herstellung eines Ein- und Ausgabegerätes (1), wobei ein Rahmen (2) nach einem der Ansprüche 8 oder 9 hergestellt wird und in eine zentrale Ausnehmung (3) des Rahmens (2) eine Ein- und Ausgabeeinheit (4) eingesetzt wird.

11. Verfahren nach Anspruch 10, **dadurch gekennzeichnet, dass** zwischen Ein- und Ausgabeeinheit (4) und Rahmen (2) ein über den Umfang geschlossenes Dichtungselement (21) angeordnet wird.

12. Verfahren nach Anspruch 10, **dadurch gekennzeichnet, dass** über die Ein- und Ausgabeeinheit (4) und der ersten Stirnseite (6) des Rahmens (2) eine Abdeckfolie (25) geklebt wird, die zumindest den Spalt zwischen dem Rahmen (2) und der Ein- und Ausgabeeinheit (4) abdeckt.

## Claims

1. A frame for an input and output device, the frame (2) being composed of a plurality of individual frame parts (2a, 2b, 2c, 2d), the frame parts (2a, 2b, 2c, 2d) being joined at abutting abutment surfaces (15) of the frame parts (2a, 2b, 2c, 2d) in order to form the frame (2), **characterized in that** in the region of an abutment surface (15), a through recess (20) is arranged which is connected to the abutment surface (15) and connects a first end face of the frame (2) to an opposite second end face of the frame (2), the through recess (20) being filled in with a sealant (26).

2. The frame according to claim 1, **characterized in that** a peripheral groove (7) is provided at the first end face (6), and the through recess (20) connects the bottom of the peripheral groove (7) to the opposite second end face.

3. The frame according to claim 1 or 2, **characterized in that** a sealing recess (23) is provided on the second end face (22) of the frame (2), and the through recess (20) connects the bottom of the sealing recess (23) to the opposite first end face.

4. The frame according to claim 3, **characterized in that** on the frame (2), a peripheral collar (24) is provided that is closed over the circumference and forms the second end face (22)

5. An input and output device for industrial applications, comprising a frame (2) according to any of claims 1 to 4, wherein an input and output unit (4) is set into a centrally continuous recess (3) of the frame.

6. The input and output device according to claim 5, **characterized in that** a sealing element (21) is arranged between the frame (2) and the input and output unit (4).

7. The input and output device according to claim 5, **characterized in that** a cover film (25) is provided, which covers at least a gap between the frame (2) and the input and output unit (4).

8. A method for producing a frame (2) for an input and output device (1), wherein frame parts (2a, 2b, 2c, 2d) are cut from a section bar to form abutment surfaces (15); the frame parts (2a, 2b, 2c, 2d) are laid one next to each other in a contiguous manner and joined at the abutment surfaces (15) to form the frame (2); a through recess (20) is formed in the region of the abutment surfaces (2a, 2b, 2c, 2d), the through recess (20) being connected to abutting abutment surfaces (2a, 2b, 2c, 2d), whereby a first end face (6) of the frame is connected to an opposite second end face of the frame (2) by a through recess (29); and the through recess (20) is filled with a sealant (26).

9. The method according to claim 8, **characterized in that** the frame (2) is externally at least partially painted, anodized, coated, or covered with an adhesive film.

10. A method for producing an input and output device (1), wherein a frame (2) according to either of claims 8 and 9 is produced and an input and output unit (4) is set into a central recess (3) of the frame (2)

11. The method according to claim 10, **characterized in that** a sealing element (21) that is closed over the circumference is arranged between the input and output unit (4) and the frame (2).

12. The method according to claim 10, **characterized in that** a cover film (25) is adhered over the input and output unit (4) and the first end face (6) of the frame (2), the cover film (25) covering at least the gap between the frame (2) and the input and output unit (4).

## Revendications

1. Cadre pour un appareil d'entrée et de sortie, le cadre (2) étant composé d'une pluralité de pièces de cadre uniques (2a, 2b, 2c, 2d), les pièces de cadre (2a, 2b, 2c, 2d) destinées à former le cadre (2) étant jointes sur des surfaces de butée (15) en butée les unes contre les autres des pièces de cadre (2a, 2b, 2c, 2d), **caractérisé en ce qu'**un évidement de passage (20) est disposé au niveau d'une surface de butée (15), qui est relié avec la surface de butée (15) et qui relie un premier côté avant du cadre (2) avec un second côté avant du cadre (2) opposé, l'évidement de passage (20) étant rempli avec une masse d'étanchéité (26).

2. Cadre selon la revendication 1, **caractérisé en ce qu'**il est prévu une rainure circonférentielle (7) sur le premier côté avant (6) du cadre et que l'évidement de passage (20) relie la base de la rainure circonférentielle (7) avec le second côté avant opposé.

3. Cadre selon la revendication 1 ou 2, **caractérisé en ce qu'**il est prévu un évidement d'étanchéité (23) sur le second côté avant (22) du cadre (2), et que l'évidement de passage (20) relie la base de l'évidement d'étanchéité (23) avec le premier côté avant opposé.

4. Cadre selon la revendication 3, **caractérisé en ce qu'**il est prévu, sur le cadre (2), une collerette circonférentielle (24) fermée au-dessus de la circonférence, qui forme le second côté avant (22).

5. Appareil d'entrée et de sortie destiné à une utilisation industrielle comportant un cadre (2) selon l'une des revendications 1 à 4, une unité d'entrée et de sortie (4) étant insérée dans un évidement (3) du cadre faisant une traversée centrale.

6. Appareil d'entrée et de sortie selon la revendication 5, **caractérisé en ce qu'**un élément d'étanchéité (21) est disposé entre le cadre (2) et l'unité d'entrée et de sortie (4).

7. Appareil d'entrée et de sortie selon la revendication 5, **caractérisé en ce qu'**il est prévu un film de protection (25), qui recouvre au moins une fente entre le cadre (2) et l'unité d'entrée et de sortie (4).

8. Procédé de fabrication d'un cadre (2) pour un appareil d'entrée et de sortie (1), les pièces du cadre (2a, 2b, 2c, 2d) étant découpées en longueur par un profil en formant des surfaces de butées (15), les pièces du cadre (2a, 2b, 2c, 2d) étant jointes et appliquées les unes contre les autres sur les surfaces de butée (15) pour former le cadre (2), un évidement de passage (20) relié aux surfaces de butée (15) étant formé au niveau des surfaces de butée (15) venant en butée les unes contre les autres, un premier côté avant (6) du cadre étant ainsi relié à un second côté avant opposé du cadre (2) par l'évidement de passage (20), et l'évidement de passage (20) est rempli avec une masse d'étanchéité (26).

9. Procédé selon la revendication 8, **caractérisé en ce que** le cadre (2) est au moins partiellement verni, anodisé, peint ou recouvert d'un film sur l'extérieur.

10. Procédé de fabrication d'un appareil d'entrée et de sortie (1), un cadre (2) selon l'une des revendications 8 ou 9 étant fabriqué et une unité d'entrée et de sortie (4) étant insérée dans un évidement central (3) du cadre (2).

11. Procédé selon la revendication 10, **caractérisé en ce qu'**un élément d'étanchéité (21) fermé au-dessus de la circonférence est disposé entre l'unité d'entrée et de sortie (4) et le cadre (2).

12. Procédé selon la revendication 10, **caractérisé en ce qu'**un film de protection (25) est collé par-dessus une unité d'entrée et de sortie (4) et le premier côté avant (6) du cadre (2), qui recouvre au moins la fente entre le cadre (2) et l'unité d'entrée et de sortie (4).
